# EUROPÄISCHE PATENTSCHRIFT

(11) **EP 2 265 745 B1**
(45) Veröffentlichungstag und Bekanntmachung des Hinweises auf die Patenterteilung: **15.01.2014**
(21) Anmeldenummer: 09722107.1
(22) Anmeldetag: 23.01.2009
(51) Int. Cl.: C23C 16/44, C23C 16/34

(54) **CVD ABGASBEHANDLUNGSVERFAHREN**
CVD EXHAUST GAS TREATMENT METHOD
PROCÉDÉ DE TRAITEMENT DES EFFLUENTS GAZEUX CVD

(30) Priorität: 17.03.2008 DE 102008014654
(43) Veröffentlichungstag der Anmeldung: 29.12.2010
(73) Patentinhaber: Robert Bosch GmbH, 70442 Stuttgart (DE)
(72) Erfinder: RUDHARD, Joachim, 70771 Leinfelden-Echterdingen (DE); MUELLER, Thorsten, 71672 Marbach (DE)
(86) Internationale Anmeldenummer: PCT/EP2009/050793
(87) Internationale Veröffentlichungsnummer: WO 2009/115359

(56) Entgegenhaltungen:
- US-A- 5 704 214
- US-A1- 2004 081 607
- US-B1- 6 383 300
- US-B1- 6 391 146

## Beschreibung

### Stand der Technik

Die Erfindung betrifft eine Abgasbehandlungsvorrichtung für eine CVD-Vorrichtung (Chemical-Vapor-Deposition-Vorrichtung) gemäß dem Oberbegriff des Anspruchs 1, eine CVD-Vorrichtung gemäß Anspruch 9 sowie ein Verfahren zum Behandeln von Abgas aus einem CVD-Prozess gemäß dem Oberbegriff des Anspruchs 10.

Für die Abscheidung von dünnen Schichten ist es bekannt, einen so genannten CVD-Prozess (Chemical-Vapor-Deposition-Process) zu realisieren. Dabei wird an der Oberfläche eines Substrates in einer CVD-Prozesskammer aufgrund einer chemischen Reaktion aus einer Gasphase eine Feststoffkomponente abgeschieden. Auch ist die Abscheidung von Schichten mittels eines LPCVD-Prozesses (Low-Pressure-Chemical-Vapor-Deposition-Process) bekannt; hierbei wird die Schicht bei niedrigem Prozessdruck abgeschieden. Insbesondere in der Halbleiter-Technologie und der MEMS-Technologie (Micro-Electro-Mechanical-System-Technologie) wird Siliziumnitrid mittels eines LPCVD-Prozesses abgeschieden. Hierzu werden DCS (Dichlorsilan) und NH₃ (Ammoniakgas) im stöchiometrischen Gleichgewicht abgeschieden. Die Reaktionschemie hierbei ist folgende:

3 SiH₂Cl₂ + NH₃ → Si₃N₄ + NH₄Cl + 5 HCl + 6H₂.

Die Abgasreinigung für einen LPCVD-Prozess zum Abscheiden von stöchiometrischem Siliziumnitrid ist verstanden und wird durch beheizte Abgasrohre bis zu einer Kühlfalle mit akzeptablem Aufwand kontrolliert.

Nachteilig bei der stöchiometrischen Nitridschicht ist, dass diese unter einer hohen Zugspannung von etwa 1 GPa steht und deswegen beispielsweise nicht beliebig dick abgeschieden werden kann. Dieser und andere Gründe führten zur Entwicklung von siliziumreichen Nitridschichten, die durch Prozessierung mit DCS-Überschuss auf den gleichen Anlagen abgeschieden werden können. Der Vorteil dieser siliziumreichen Nitridschichten ist, dass der Schichtstress dieser Schichten über einen großen Zugspannungsbereich sogar bis hin zu einer leichten Druckspannung eingestellt werden kann. Nachteilig bei der Prozessierung mit DCS-Überschuss ist, dass sich die entstehenden, im Abgas enthaltenen Reaktionsprodukte in der Abgasstrecke an Rohren, Ventilen und in der Kühlfalle absetzen, was nach kürzester Zeit zu einem Ausfall von Bauteilen der Abgasstrecke führt.

In der EP 0 839 929 B1 ist eine bekannte Abgasreinigungsvorrichtung für einen CVD-Prozess beschrieben. Hierbei wird in der Abgasstrecke ein Plasma durch den Einsatz von Mikrowellen erzeugt.

Aus der US 2004/0081607 A1 ist ein Abgasbehandlungsvorrichtung für Prozessgase bekannt, um Verunreinigungsgase aus dem Prozessraum zu entfernen. Hierbei wird TiCl_{X} Gas aus dem Abgasstrom mittels einer Kühlfalle nach Ammoniak-Zusätzung entfernt.

Aus der US 6,383,300 B1 ist eine Abgas-Reinigungseinrichtung für eine CVD-Beschichtungsanlage für Siliziumdioxid bzw. Siliziumnitridfilme bekannt. Eine Abgasleitung wird hierbei beheizt, wobei das Abgas zunächst einer ersten Gasfalle für Kohlenwasserstoffe und anschließend eine Kühlfalle für Ammonium-chlorid zugeführt wird.

Aus der US 6,381,146 B1 ist ebenfalls eine Vorrichtung für das Entfernen von gefährlichen Gasen aus einer Prozesskammer bekannt.

Aus der US 5,704,214 ist ebenfalls eine Abgasreinigungseinrichtung mittels einer Kühlfalle bekannt.

### Offenbarung der Erfindung

### Technische Aufgabe

Der Erfindung liegt die Aufgabe zugrunde, ein Verfahren zum Behandeln von Abgas aus einem CVD-Prozess vorzuschlagen, bei dem siliziumreiches Nitrid abgeschieden wird.

### Technische Lösung

Diese Aufgabe wird mit den Merkmalen des Anspruchs 1 gelöst. Vorteilhafte Weiterbildungen der Erfindung sind in den Unteransprüchen angegeben.

Der Erfindung liegt der Gedanke zugrunde, eine dem eigentlichen CVD-Prozess, insbesondere dem LPCVD-Prozess, nachgeordnete Nachbehandlungskammer zur Abgasbehandlung zuzuordnen, wobei in die Nachbehandlungskammer Ammoniakgas (NH₃) dosierbar ist. Durch das Zudosieren von Ammoniakgas zum Abgas des CVD-Prozesses wird das Abscheiden von Siliziumnitrid in der Nachbehandlungskammer erzwungen, wobei durch die Reaktion von Dichlorsilan (DCS) und Ammoniakgas die üblichen, mit herkömmlichen Abgasbehandlungsmethoden beherrschbaren Reaktionsnebenprodukte entstehen. Um das Abscheiden großer Mengen an, insbesondere stöchiometrischem, Siliziumnitrid zu ermöglichen, ist es vorteilhaft, in der Nachbehandlungskammer eine große Reaktionsoberfläche vorzusehen. Die Nachbehandlungskammer kann also ähnlich wie die eigentliche Prozesskammer des DVD-Prozesses aufgebaut werden. Es ist auch denkbar, eine Abgasleitung als Nachbehandlungskammer vorzusehen, in die Ammoniakgas einleitbar ist. Durch das Zudosieren von Ammoniakgas in das Abgas des CVD-Prozesses können die Reaktionsprodukte, die beim Abscheiden von siliziumreichem Nitrid in der eigentlichen CVD-Prozesskammer entstehen, zumindest minimiert werden, wodurch die der Nachbehandlungskammer nachgeordnete, in vorzugsweise mindestens eine Kühlfalle umfassende, Abgasstrecke entlastet wird.

Um den Abgasbehandlungsprozess kontrollieren bzw. gezielt steuern zu können, ist eine Ausführungsform bevorzugt, bei der die zum Abgas zu dosierende Ammoniakgasmenge derart einstellbar ist, dass stöchiometrisches Nitrid abgeschieden wird. Anders ausgedrückt, wird zumindest näherungsweise so viel Ammoniakgas nachdosiert, dass im Abgas, insbesondere in der Nachbehandlungskammer, ein stöchiometrisches Gleichgewicht zwischen DCS und NH₃ resultiert, so dass die Nachbehandlungskammer zumindest im Wesentlichen ausschließlich Abgas verlässt, das von seiner Zusammensetzung her zumindest näherungsweise dem Abgas eines stöchiometrischen CVD-Abscheidungsprozesses zum Abscheiden von stöchiometrischem Nitrid entspricht. Gegebenenfalls kann die zum Abgas zu dosierende Ammoniakgasmenge auch derart gewählt werden, dass ein Ammoniakgasüberschuss in der Nachbehandlungskammer resultiert. Ein Ammoniakgasüberschuss im die Nachbehandlungskammer verlassenden Abgas kann verfahrenstechnisch verhältnismäßig einfach beherrscht werden.

Von besonderem Vorteil ist eine Ausführungsform der Abgasbehandlungsvorrichtung, bei der diese derart ausgebildet ist, dass die in das Abgas zu dosierende Ammoniakgasmenge in Abhängigkeit des CVD-Prozessflussverhältnisses von Dichlorsilan zu Ammoniakgas ermittelt wird. Anders ausgedrückt umfasst die Abgasbehandlungsvorrichtung Mittel zur Bestimmung des Prozessflussverhältnisses von Dichlorsilan zu Ammoniakgas, wobei das Prozessflussverhältnis der beiden Substanzen bei der Bestimmung der nachzudosierenden Ammoniakmenge berücksichtigt wird. Zusätzlich oder alternativ kann die nachzudosierende Ammoniakmenge in Abhängigkeit der Ammoniakgasmenge (Konzentration) und/oder der Dichlorsilanmenge (Konzentration) im Abgas des CVD-Prozesses bestimmt werden. Anders ausgedrückt umfasst die Abgasbehandlungsvorrichtung gemäß dieser Ausführungsform Mittel zur Bestimmung der Ammoniakgasmenge und/oder der Dichlorsilanmenge im Abgas, insbesondere zur Erfassung der Ammoniakgasmenge und/oder der Dichlorsilanmenge in der Nachbehandlungskammer. Insbesondere dann, wenn es sich um eine langgestreckte Nachbehandlungskammer handelt, also die Nachbehandlungskammer in der Art eines Abgasrohrs ausgebildet ist, ist es möglich, Ammoniakgas an mindestens zwei in Fließrichtung des Abgases beabstandeten Stellen der Nachbehandlungskammer zuzudosieren, insbesondere in Abhängigkeit der jeweiligen Dichlorsilankonzentration und/oder der jeweiligen Ammoniakgaskonzentration im Bereich der jeweiligen Zudosierstelle.

Besonders bevorzugt ist eine Ausführungsform der Abgasbehandlungsvorrichtung, bei der diese eine Logikeinheit zum Ermitteln und Regeln der zuzudosierenden Ammoniakgasmenge aufweist. Dabei ist eine Ausführungsform realisierbar, bei der in der Logikeinheit bzw. in einem Speicher der Logikeinheit eine Tabelle hinterlegt ist, aus der in Abhängigkeit mindestens eines zu bestimmenden Wertes die zum Abgas zu dosierende Ammoniakgasmenge bestimmbar ist. Zusätzlich oder alternativ zu einer Tabelle kann auch ein entsprechender Berechnungs-Algorithmus hinterlegt sein. Ist also beispielsweise das CVD-Prozessflussverhältnis von Dichlorsilan zu Ammoniakgas bekannt, so kann die Logikeinheit anhand der Tabelle und/oder mittels des Algorithmus die zum Abgas zu dosierende Ammoniakgasmenge bestimmen. Alternativ ist die nachzudosierende Ammoniakgasmenge beispielsweise anhand der zu messenden Dichlorsilanmenge (Konzentration) im Abgas anhand der Tabelle und/oder mittels des Algorithmus bestimmbar. Die Logikeinheit kann Bestandteil eines Dosier-Ammoniakgasdurchflussmengenreglers sein, der zur Nachdosierung von Ammoniakgas in die Nachbehandlungskammer vorgesehen werden kann.

Um die Logikeinheit mit aktuellen Daten, insbesondere Messdaten, zu versorgen, ist eine Ausführungsform bevorzugt, bei der die Logikeinheit signalleitend mit mindestens einem CVD-Prozess-Dichlorsilandurchflussmengenmesser und/oder mit einem CVD-Prozess-Ammoniakgasdurchflussmengenmesser zum Ermitteln des CVD-Prozessflussverhältnisses verbunden ist. Zusätzlich oder alternativ kann die Logikeinheit auch mit einem Dichlorsilandurchflussmengenregler (Massflowcontroller) und/oder einem Ammoniakgasdurchflussmengenregler (Massflowcontroller) verbunden sein, die bzw. der die aktuellen Durchflussmengen an die Logikeinheit weiterleiten/weiterleitet. In Weiterbildung der Erfindung ist mit Vorteil vorgesehen, dass die Logikeinheit Bestandteil eines Dosier-Ammoniakgasdurchflussmengenreglers (Massflow-controller) ist.

Von besonderem Vorteil ist eine Ausführungsform, bei der die Logikeinheit signalleitend mit einem Ammoniaksensor zur Bestimmung der Ammoniakmenge, insbesondere der Ammoniakkonzentration, im Abgas des CVD-Prozesses, insbesondere in der Nachbehandlungskammer, und/oder mit einem Dichlorsilansensor zur Bestimmung der Dichlorsilanmenge, insbesondere der Dichlorsilankonzentration, im Abgas, vorzugsweise in der Nachbehandlungskammer, verbunden ist. Dabei kann die Ermittlung der nachzudosierenden Ammoniakgasmenge bei Bedarf ausschließlich auf Basis dieser Sensordaten ermittelt werden. Besonders bevorzugt ist jedoch eine Ausführungsform, bei der diese Sensorinformationen zusätzlich zu dem CVD-Prozessflussverhältnis ermittelt werden, um die tatsächlich benötigte Ammoniakgasmenge möglichst exakt bestimmen zu können.

In Weiterbildung der Erfindung ist mit Vorteil vorgesehen, dass die Nachbehandlungskammer in der Art einer CVD-Prozesskammer ausgebildet ist. Anders ausgedrückt ist vorzugsweise neben einer großen Reaktionsoberfläche eine Heizung zum Beheizen der Nachbehandlungskammer, insbesondere, zumindest näherungsweise, auf CVD-Prozesstemperatur, vorgesehen, um ein Abscheiden von stöchiometrischem Nitrid zu begünstigen. Für den Fall, dass der Nachbehandlungskammer noch eine Abgasleitung nachgeschaltet ist, die zu einer Kühlfalle zum Abscheiden von Ammoniumchlorid führt, ist eine Ausführungsform bevorzugt, bei der diese Abgasleitung, vorzugsweise vollständig, zumindest jedoch abschnittsweise, ebenfalls, vorzugsweise näherungsweise, auf CVD-Prozesstemperatur, erhitzbar ist, um auch noch in der Abgasleitung ein Abscheiden von stöchiometrischem Nitrid zu ermöglichen.

Neben der Abgasbehandlungsvorrichtung führt die Erfindung auch auf eine CVD-Vorrichtung mit einer zuvor beschriebenen Abgasbehandlungsvorrichtung, wobei die Abgasbehandlungsvorrichtung in Strömungsrichtung einer CVD-Prozesskammer nachgeordnet ist.

Darüber hinaus führt die Erfindung auf ein Verfahren zum Behandeln von Abgas aus einem CVD-Prozess, insbesondere aus einem LPCVD-Prozess, in dem siliziumreiches Nitrid, insbesondere auf einem Substrat, abgeschieden wird. Erfindungsgemäß ist vorgesehen, dass zu dem Abgas aus dem CVD-Prozess Ammoniakgas zudosiert wird, vorzugsweise derart, dass aus dem Abgas stöchiometrisches Nitrid abgeschieden wird. Durch das Zudosieren von Ammoniakgas in das Abgas des CVD-Prozesses werden ein Dichlorsilanüberschuss im Abgas sowie daraus resultierende, aggressive Reaktionsprodukte zumindest reduziert, vorzugsweise vollständig ausgeglichen, mit dem Vorteil, dass Standardreaktionsprodukte, insbesondere NH₄Cl, HCl und H₂, wie bei einer stöchiometrischen CVD-Prozessführung erhalten werden.

In Weiterbildung der Erfindung ist mit Vorteil vorgesehen, dass die zu dem Abgas dosierbare Ammoniakgasmenge derart eingestellt wird, dass aus dem Abgas stöchiometrisches Nitrid abgeschieden wird und/oder dass ein, vorzugsweise nur geringer, Ammoniakgasüberschuss im Abgas resultiert.

In Weiterbildung der Erfindung ist mit Vorteil vorgesehen, dass die zu dem Abgas dosierbare Ammoniakgasmenge in Abhängigkeit des CVD-Prozessflussverhältnisses von Dichlorsilan zu Ammoniakgas bestimmt wird, wobei hierzu vorzugsweise der den CVD-Prozess zugeführte Dichlorsilanvolumenstrom und der dem CVD-Prozess zugeführte Ammoniakgasvolumenstrom bestimmt bzw. ermittelt werden. Zusätzlich oder alternativ kann die zu dem Abgas dosierbare Ammoniakmenge in Abhängigkeit der Ammoniakgasmenge (Ammoniakgaskonzentration) oder der Dichlorsilanmenge (Dichlorsilankonzentration) im Abgas des CVD-Prozesses, insbesondere in einer Nachbehandlungskammer, eingestellt werden. Hierzu ist die Ammoniakgaskonzentration und/oder die Dichlorsilankonzentration im Abgas mit Hilfe geeigneter Sensoren zu bestimmen.

Von besonderem Vorteil ist eine Ausführungsform, bei der zur Beschleunigung der Reaktion das Abgas und/oder das zum Abgas dosierbare Ammoniakgas beheizt werden, vorzugsweise auf CVD-Prozesstemperatur.

### Kurze Beschreibung der Zeichnungen

Weitere Vorteile, Merkmale und Einzelheiten der Erfindung ergeben sich aus der nachfolgenden Beschreibung eines bevorzugten Ausführungsbeispiels sowie anhand der Zeichnungen. Diese zeigen in:
- Fig. 1:: eine CVD-Vorrichtung mit einer einer CVD-Prozesskammer nachgeschalteten Abgasbehandlungsvorrichtung und
- Fig. 2:: eine alternative CVD-Vorrichtung.

### Kurze Beschreibung der Zeichnungen

In den Figuren sind gleiche Bauteile und Bauteile mit der gleichen Funktion mit den gleichen Bezugszeichen gekennzeichnet.

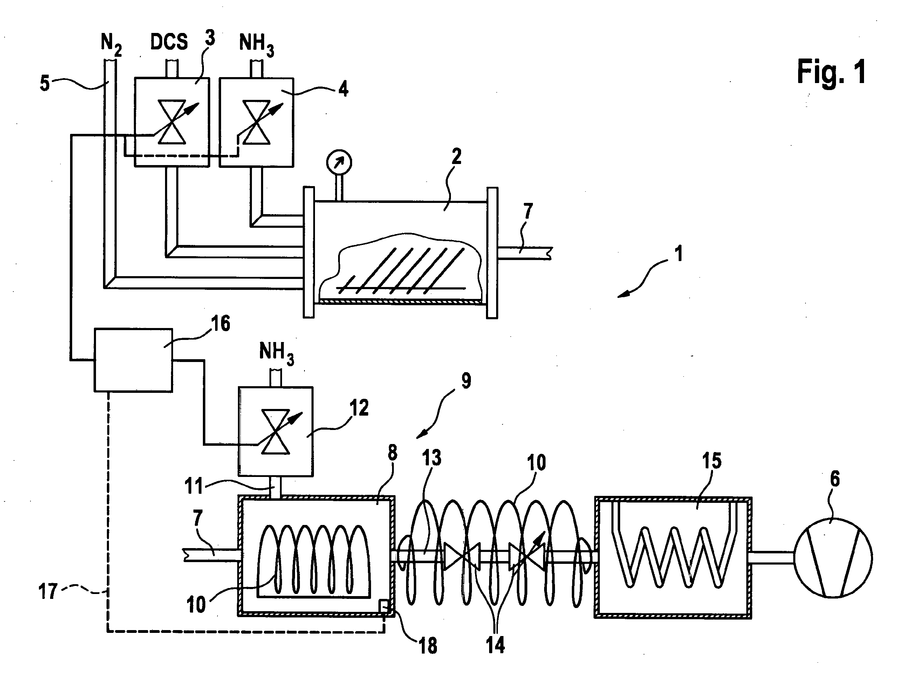

In Fig. 1 ist eine CVD-Vorrichtung 1 zur Durchführung eines LPCVD-Prozesses zur Abscheidung von siliziumreichem Nitrid gezeigt. Die CVD-Vorrichtung umfasst eine CVD-Prozesskammer 2, die in an sich bekannter Weise ausgebildet ist. Die CVD-Prozesskammer weist in ihrem Inneren ein oder mehrere Substrate bis hin zu typischerweise verwendeten Batchprozessgrößen mit einer großen Reaktionsfläche auf und ist beheizbar (nicht dargestellt).

Der CVD-Prozesskammer 2 ist ein Dichlorsilandurchflussmengenregler 3 (Massflowcontroller) zugeordnet, über den der Dichlorsilan(DCS-)-Prozessfluss einstellbar ist. Weiterhin ist der CVD-Prozesskammer 2 ein Ammoniakgasdurchflussmengenregler 4 (Massflowcontroller) zugeordnet, über den der Ammoniakgas(NH₃)-Prozessfluss regelbar ist. Darüber hinaus führt eine Stickstoff(N₂)-Leitung 5 in die CVD-Prozesskammer 2, insbesondere zu Spülzwecken.

Bei der gezeigten CVD-Vorrichtung 1 wird Dichlorsilan im Überschuss in die CVD-Prozesskammer 2 eingeleitet, so dass sich unter von einer Pumpe 6 erzeugtem Unterdruck siliziumreiches Nitrid in der CVD-Prozesskammer 2 auf dem Substrat/ den Substraten abscheidet.

Aus der CVD-Prozesskammer 2 mündet ein Abgasrohr 7 aus, welches zu einer Nachbehandlungskammer 8 einer Abgasbehandlungsvorrichtung 9 führt. Die Nachbehandlungskammer 8 ist mit einer Heizung 10 zur Beheizung des Innenvolumens der Nachbehandlungskammer 8 auf CVD-Prozesstemperatur ausgestattet.

In die Nachbehandlungskammer 8 ist Ammoniakgas dosierbar. Hierzu mündet in die Nachbehandlungskammer 8 eine Dosierleitung 11 (alternativ mündet die Dosierleitung 11 in das Abgasrohr 7). Die Dosierleitung 11 verbindet einen Dosier-Ammoniakgasdurchflussmengenregler 12 (Massflowcontroller) mit der Nachbehandlungskammer 8. Aus der Nachbehandlungskammer 8 mündet eine Abgasleitung 13 aus, die über Ventile 14 zu einer Kühlfalle 15 führt, in der Ammoniumchlorid abgeschieden wird. Die Abgasstrecke, die auf die Nachbehandlungskammer 8 folgt, entspricht einer an sich bekannten Abgasstrecke für einen stöchiometrischen Nitrid-Abscheideprozess. Der Kühlfalle 15 ist die Pumpe 6 zum Befördern des Abgases und zur Erzeugung eines Unterdrucks in CVD-Prozesskammer 2 sowie in der Nachbehandlungskammer 8 nachgeordnet.

Der Dosier-Ammoniakgasdurchflussmengenregler 12 wird über eine Logikeinheit 16 angesteuert, die signalleitend wohl mit dem Dichlorsilandurchflussmengenregler 3 als auch mit dem Ammoniakgasdurchflussmengenregler 4 verbunden ist. Die Logikeinheit 16 bestimmt die in die Nachbehandlungskammer 8 zu dosierende Ammoniakgasmenge in Abhängigkeit des CVD-Prozessflussverhältnisses von Dichlorsilan zu Ammoniakgas. Dabei wird die zu dosierende Ammoniakgasmenge in dem gezeigten Ausführungsbeispiel von der Logikeinheit 16 anhand einer Tabelle bestimmt, derart, dass sich im Abgas in der Nachbehandlungskammer 8 zumindest näherungsweise ein stöchiometrisches Verhältnis von Dichlorsilan und Ammoniakgas einstellt, so dass der aus dem CVD-Prozess überbleibende Dichlorsilanüberschuss durch die Abscheidung von Nitrid in der Nachbehandlungskammer 8 auf die Standardreaktionsprodukte (NH₄Cl, HCl, H₂) einer stöchiometrischen Prozessführung reduziert wird. Um den Abgas-Reaktionsprozess bis zur Kühlfalle 15 aufrecht zu erhalten, ist auch die Abgasleitung 13 mittels einer Heizung 10 beheizbar.

Strichliert ist eine Signalleitung 17 dargestellt, die fakultativ zusätzlich vorgesehen werden kann. Die Signalleitung 17 verbindet einen Ammoniakgassensor 18 (ebenfalls fakultativ) mit der Logikeinheit 16, so dass Ammoniakgas bei Bedarf nachgeregelt werden kann, falls der Ammoniakgassensor 18 einen zu niedrigen Wert ermitteln sollte.

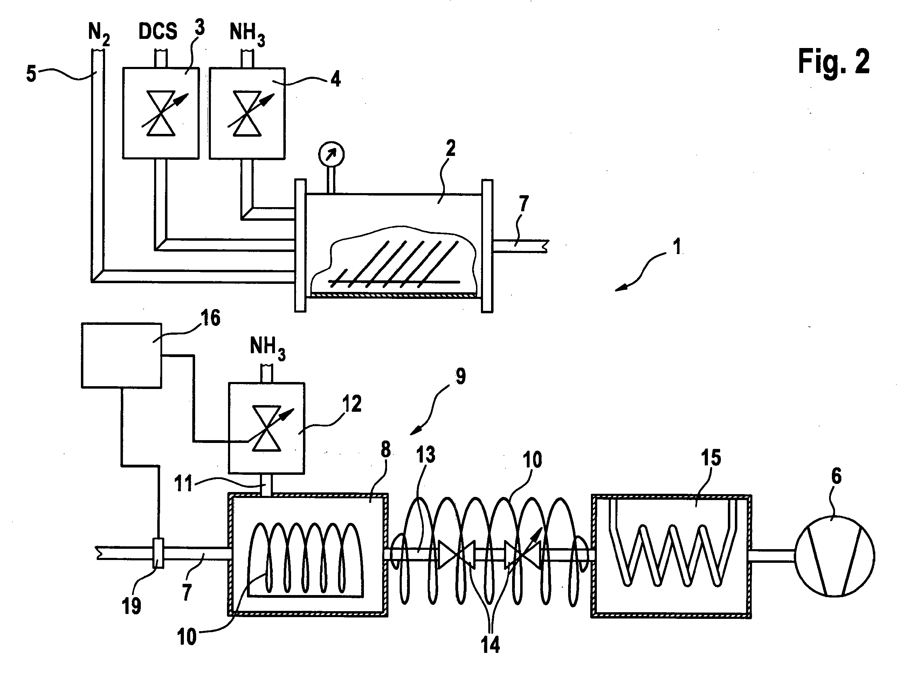

In Fig. 2 ist ein alternatives Ausführungsbeispiel einer CVD-Vorrichtung 1 mit einer Abgasbehandlungsvorrichtung 9 gezeigt. Dabei entspricht die CVD-Vorrichtung 1 im Wesentlichen dem Ausführungsbeispiel gemäß Fig. 1, so dass zur Vermeidung von Wiederholungen im Folgenden im Wesentlichen nur auf die Unterschiede zu dem Ausführungsbeispiel gemäß Fig. 1 eingegangen wird. Im Hinblick auf die Gemeinsamkeiten wird auf die vorangehende Figurenbeschreibung sowie Fig. 1 verwiesen.

Im Gegensatz zu dem Ausführungsbeispiel gemäß Fig. 1 erfolgt die Bestimmung der in die Nachbehandlungskammer 8 zu dosierenden Ammoniakgasmenge in Abhängigkeit der Dichlorsilankonzentration im Abgas. Hierzu ist in dem Abgasrohr 8 ein Dichlorsilansensor 19 integriert, der signalleitend mit der Logikeinheit 16 verbunden ist, welche wiederum den Dosier-Ammoniakgasdurchflussmengenregler 12 ansteuert. Zusätzlich oder alternativ zu einem Dichlorsilansensor 19 in dem Abgasrohr 7 kann im Abgasrohr 7 auch ein Ammoniakgassensor 18 zur Bestimmung der Ammoniakgaskonzentration im Abgas vorgesehen werden. Die entsprechenden Sensoren können bei Bedarf auch in der Nachbehandlungskammer 8 vorgesehen werden. Anders als bei dem Ausführungsbeispiel gemäß Fig. 1 wird also die zu dem Abgas zu dosierende Ammoniakgasmenge nicht unmittelbar aus dem CVD-Prozessflussverhältnis von Dichlorsilan zu Ammoniakgas ermittelt, sondern auf Basis einer direkten Messung der Dichlorsilanmenge und/oder der Ammoniakgasmenge im Abgas.

## Patentansprüche

1. Verfahren zum Behandeln von Abgas aus einem CVD-Prozess, insbesondere aus einem LPCVD-Prozess, in dem siliziumreiches Nitrid abgeschieden wird, wobei zu dem Abgas aus dem CVD-Prözess Ammoniakgas dosiert wird, **dadurch gekennzeichnet, dass** das Abgas und das zum Abgas dosierbare Ammoniakgas, durch mindestens eine Heizung (10) zum Beheizen einer Nachbehandlungskammer (8) und zum Beheizen einer zu einer Kühlfalle (15) zum Abscheiden von Ammoniumchlorid führenden Abgasleitung (13) zumindest näherungsweise auf CVD-Prozesstemperatur, beheizt werden.

2. Verfahren nach Anspruch 1, **dadurch gekennzeichnet, dass** die zu dem Abgas dosierbare Ammoniakgasmenge derart eingestellt wird, dass stöchiometrisches Nitrid abgeschieden wird oder dass ein geringer Ammoniakgasüberschuss im Abgas resultiert.

3. Verfahren nach einem der vorhergehenden Ansprüche, **dadurch gekennzeichnet, dass** die zu dem Abgas dosierbare Ammoniakmenge in Abhängigkeit des CVD-Prozessflussverhältnisses von Dichlorsilan zu Ammoniakgas oder in Abhängigkeit der Ammoniakgasmenge oder der Dichlorsilanmenge im Abgas des CVD-Prozesses eingestellt wird.

## Claims

1. Method for the treatment of exhaust gas from a CVD process, in particular from an LPCVD process, in which silicon-rich nitride is separated, ammonia gas being metered to the exhaust gas from the CVD process, **characterized in that** the exhaust gas and the ammonia gas meterable to the exhaust gas are heated, at least approximately to CVD process temperature, by means of at least one heating system (10) for heating an aftertreatment chamber (8) and for heating an exhaust gas line (13) leading to a cold trap (15) for the separation of ammonium chloride.

2. Method according to Claim 1, **characterized in that** the ammonia gas quantity meterable to the exhaust gas is set in such a way that stoichiometric nitride is separated or in such a way as to result in a slight excess of ammonia gas in the exhaust gas.

3. Method according to one of the preceding claims, **characterized in that** the ammonia quantity meterable to the exhaust gas is set as a function of the CVD process flow ratio of dichlorosilane to ammonia gas or as a function of the ammonia gas quantity or of the dichlorosilane quantity in the exhaust gas of the CVD process.

## Revendications

1. Procédé de traitement des effluents gazeux d'un processus CVD, en particulier d'un processus LPCVD, dans lequel on dépose un nitrure riche en silicium, dans lequel on dose du gaz ammoniac dans les effluents gazeux du processus CVD, **caractérisé en ce que** l'on chauffe les effluents gazeux et le gaz ammoniac dosable dans les effluents gazeux au moins approximativement à la température du processus CVD par au moins un chauffage (10) destiné au chauffage d'une chambre de post-traitement (8) et au chauffage d'une conduite d'effluents gazeux (13) conduisant à un piège de refroidissement (15) pour le dépôt de chlorure d'ammonium.

2. Procédé selon la revendication 1, **caractérisé en ce que** l'on règle la quantité de gaz ammoniac dosable dans les effluents gazeux d'une manière telle que l'on dépose un nitrure stoechiométrique ou qu'il en résulte un léger excès de gaz ammoniac dans les effluents gazeux.

3. Procédé selon l'une des revendications précédentes, **caractérisé en ce que** l'on règle la quantité de gaz ammoniac dosable dans les effluents gazeux en fonction du rapport de flux du processus CVD du dichlorosilane au gaz ammoniac ou en fonction de la quantité de gaz ammoniac ou de la quantité de dichlorosilane dans les effluents gazeux du processus CVD.
